# FASCICULE DE BREVET EUROPEEN

(11) **EP 4 020 600 B1**
(45) Date de publication et mention de la délivrance du brevet: **19.07.2023**
(21) Numéro de dépôt: 21215893.5
(22) Date de dépôt: 20.12.2021
(51) Int. Cl.: H01L 31/0203, H01L 31/02, H01L 31/0232, H01L 31/0352, H01L 31/18, H01L 27/146, H01L 21/683

(54) **PROCÉDÉ DE MISE EN COURBURE COLLECTIVE DE COMPOSANTS MICROÉLECTRONIQUES**
VERFAHREN ZUR KOLLEKTIVEN BIEGUNG VON MIKROELEKTRONISCHEN BAUTEILEN
METHOD FOR COLLECTIVE CURVATURE OF MICROELECTRONIC COMPONENTS

(30) Priorité: 22.12.2020 FR 2013960
(43) Date de publication de la demande: 29.06.2022
(73) Titulaire: Commissariat à l'Énergie Atomique et aux Énergies Alternatives, 75015 Paris (FR)
(72) Inventeur: ROCHAS, Alexis, 38054 Grenoble Cedex 09 (FR); HENRY, David, 38054 Grenoble Cedex 09 (FR); CAPLET, Stéphane, 38054 Grenoble Cedex 09 (FR)
(74) Mandataire: INNOV-GROUP

(56) Documents cités:
- JP-A- 2020 109 821
- US-A1- 2009 115 875
- US-A1- 2018 145 107
- US-A1- 2020 185 444
- CHAMBION BERTRAND ET AL: "Collective Curved CMOS Sensor Process: Application for High-Resolution Optical Design and Assembly Challenges", 2019 IEEE 69TH ELECTRONIC COMPONENTS AND TECHNOLOGY CONFERENCE (ECTC), IEEE, 28 mai 2019 (2019-05-28), pages 535-542, XP033603657, DOI: 10.1109/ECTC.2019.00087
- WU HAO ET AL: "Fabrication Techniques for Curved Electronics on Arbitrary Surfaces", ADVANCED MATERIALS TECHNOLOGIES, vol. 5, no. 8, 20 mai 2020 (2020-05-20), page 2000093, XP055833808, DE ISSN: 2365-709X, DOI: 10.1002/admt.202000093

## Description

### DOMAINE TECHNIQUE

Le domaine de l'invention est celui des procédés de mise en courbure collective et de packaging de composants microélectroniques. Un tel procédé peut être de type WLCSP (pour *Wafer-level Chip-Scale Packaging,* en anglais), c'est-à-dire à l'échelle de la plaque (*wafer* en anglais) et de telle sorte que l'ensemble formé du composant microélectronique et de son support d'interconnexion électrique présente des dimensions latérales du même ordre que celles du composant microélectronique.

### ÉTAT DE LA TECHNIQUE ANTÉRIEURE

Il peut être souhaitable de disposer de composants microélectroniques, et en particulier de composants optoélectroniques, présentant une courbure prédéfinie vis-à-vis d'un plan de référence. C'est le cas notamment lorsqu'il s'agit de composants optiques de détection ou d'émission d'un rayonnement lumineux, dont la courbure permet d'améliorer leurs performances optiques, par exemple en compensant la courbure de champ ou en corrigeant au moins partiellement l'astigmatisme. Dans le cas de composants optiques en émission, la courbure permet d'améliorer la mise en forme du rayonnement lumineux émis.

La réalisation et le packaging de tels composants microélectroniques peuvent être effectués à l'échelle du wafer, c'est-à-dire à partir d'une même plaque semiconductrice comportant une pluralité de circuits intégrés identiques destinés à former chacun l'un des composants microélectroniques. Le packaging consiste en l'ensemble des étapes d'assemblage du composant microélectronique dans un boîtier ou un support permettant d'établir la connexion électrique de ce dernier à un circuit électrique externe, et éventuellement d'en améliorer les performances (gestion thermique, protection mécanique, fiabilité...).

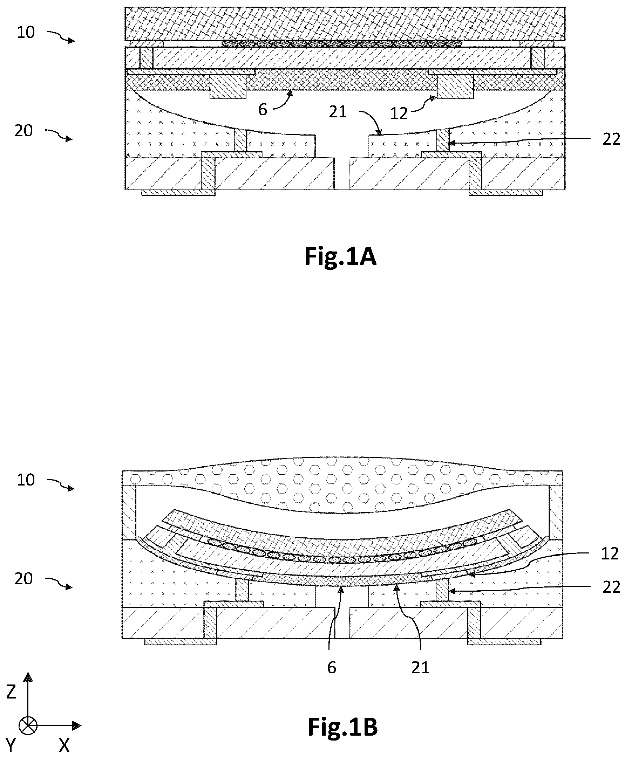

Le document US2009/0115875A1 décrit un exemple de procédé de mise en courbure collective de composants microélectroniques 10, ici des composants optiques, sur un support 20 de mise en forme et d'interconnexion électrique. Les composants microélectroniques 10 sont tout d'abord réalisés à partir d'un même substrat fonctionnalisé. Comme l'illustre la figure 1A, ils sont ensuite individualisés par découpe (*dicing,* en anglais), ici partielle, puis reportés sur le même support de mise en forme 20. Ce dernier présente une pluralité de surfaces courbées 21 (ici concaves). Il comporte également des interconnexions électriques permettant d'établir la connexion électrique entre les composants microélectroniques 10 et un circuit électrique externe (non représenté), dont des vias conducteurs 22 qui débouchent sur les surfaces courbées 21.

Avant l'étape de report et d'assemblage, les composants microélectroniques 10 sont réalisés de sorte qu'une couche inférieure adhésive 6 recouvre leur face inférieure 10i. De plus, pour assurer la connexion électrique des composants microélectroniques 10, des plots conducteurs inférieurs 12 sont réalisés, qui font saillie hors de la face libre de la couche inférieure adhésive 6.

Ensuite, comme l'illustre la figure 1B, les composants microélectroniques 10 sont reportés sur les surfaces courbées 21, et déformés de sorte que la couche inférieure adhésive 6 vienne au contact de la surface courbée 21. Il y a alors contact entre les plots conducteurs inférieurs 12 et les vias conducteurs 22, permettant ainsi la connexion électrique des composants microélectroniques 10. Or, il apparaît qu'un tel procédé de mise en courbure peut induire une courbure des composants microélectroniques 10 qui n'est pas celle effectivement désirée.

On connaît par ailleurs les documents US2018/145107A1, US2020/ 185444A1, JP2020109821A, la publication de Chambion et al. intitulée Collective Curved CMOS Sensor Process: Application for High-Resolution Optical Design and Assembly Challenges, IEEE 69th Electronic Components and Technology Conférence, 535-542 (2019), et la publication de Wu Hao et al. intitulée Fabrication Techniques for Curved Electronics on Arbitrary Surfaces, Adv. Mater. Technol., 2000093 (2020).

### EXPOSÉ DE L'INVENTION

L'invention a pour objectif de remédier au moins en partie aux inconvénients de l'art antérieur, et plus particulièrement de proposer un procédé de mise en courbure collective de composants microélectroniques qui permet d'obtenir une courbure effective des composants microélectroniques aussi proche que possible de la courbure souhaitée.

Pour cela, l'objet de l'invention, tel que défini dans la revendication 1, est un procédé de mise en courbure collective de composants microélectroniques, comportant les étapes suivantes :
o réalisation d'une structure microélectronique, comportant un substrat microélectronique, présentant une face supérieure et une face inférieure opposée, comportant une pluralité de composants microélectroniques, lesquels comportent chacun des plots conducteurs inférieurs situés sur la face inférieure et destinés à permettre la connexion électrique du composant microélectronique ;
o fourniture d'un support de mise en forme, présentant une face supérieure et une face inférieure opposée, la face supérieure comportant une pluralité de surfaces courbées ;
o dépôt d'une couche inférieure adhésive présentant une épaisseur supérieure à l'épaisseur des plots conducteurs inférieurs, de manière à, soit recouvrir entièrement la face inférieure du substrat microélectronique et les plots conducteurs inférieurs de sorte que la couche inférieure adhésive présente une face inférieure libre continue et donc non traversée par des plots conducteurs inférieurs qui seraient en saillie hors de cette couche inférieure adhésive, soit recouvrir les surfaces courbées ;
o découpe d'au moins le substrat microélectronique pour individualiser les composants microélectroniques ; puis
o report des composants microélectroniques sur le support de mise en forme ; puis
o mise en courbure des composants microélectroniques, la couche inférieure adhésive étant alors au contact de la face inférieure des composants microélectronique et de la surface courbée correspondante, évitant ainsi que des plots conducteurs inférieurs ne soient au contact de la surface courbée ; puis
o réalisation de vias conducteurs s'étendant au travers du support de mise en forme et de la couche inférieure adhésive, à partir de la face inférieure du support de mise en forme pour déboucher sur les plots conducteurs inférieurs.

Notons que l'épaisseur des plots conducteurs inférieurs est l'épaisseur maximale que ces plots peuvent présenter vis-à-vis de la face inférieure du substrat microélectronique. Autrement dit, quels que soient les plots conducteurs inférieurs qui s'étendent à partir de la face inférieure, ils sont recouverts entièrement par la couche adhésive. Cela implique que les vias conducteurs traversent non seulement le support de mise en forme, mais également la couche inférieure adhésive, pour venir contacter les plots conducteurs inférieurs.

Certains aspects préférés mais non limitatifs de ce procédé sont les suivants.

Les plots conducteurs inférieurs peuvent être disposés sur une ligne de niveau d'une face inférieure du composant microélectronique, la ligne de niveau étant prédéterminée comme étant une ligne d'égale distance à la face inférieure du support de mise en forme, lorsque le composant microélectronique est assemblé au support de mise en forme et est incurvé selon la courbure de la surface courbée, les vias conducteurs présentant une dimension verticale uniforme.

Après l'étape de mise en courbure, le procédé comporte une étape d'assemblage d'un substrat poignée au support de mise en forme du côté des surfaces courbées, de manière à permettre la manipulation de l'empilement ainsi obtenu lors de l'étape de réalisation des vias conducteurs.

Le substrat poignée assemblé au support de mise en forme peut être assemblé à une extrémité libre de parois latérales, lesquels étant situés entre et entourant les surfaces courbées.

Chaque composant microélectronique peut comporter des plots conducteurs supérieurs situés sur la face supérieure du substrat microélectronique, et des vias conducteurs traversant ce dernier pour déboucher sur la face inférieure du substrat microélectronique, de manière à entourer la ligne de niveau.

Les plots conducteurs inférieurs peuvent être disposés au contact de vias conducteurs des composants microélectronique, ou peuvent être décalés vis-à-vis de ces vias conducteurs et en sont reliés par des lignes conductrices.

Lors de la réalisation de la structure microélectronique, le procédé peut comporter une opération d'assemblage d'un substrat poignée temporaire au substrat microélectronique du côté de sa face supérieure.

Le procédé peut comporter une étape d'amincissement du substrat microélectronique, à partir de sa face inférieure opposée au substrat poignée temporaire assemblé au substrat microélectronique.

Après l'étape de report et avant l'étape de mise en courbure, le substrat poignée temporaire assemblé au substrat microélectronique peut être retiré de chaque composant microélectronique.

Le support de mise en forme peut être réalisé en un seul bloc et en un même matériau.

Le support de mise en forme peut être réalisé en un matériau thermiquement conducteur.

Les composants microélectroniques peuvent être des composants optiques d'émission ou de détection d'un rayonnement lumineux.

Lors de l'étape de report des composants microélectroniques sur le support de mise en forme, les composants microélectroniques peuvent tous être assemblés à un même substrat poignée temporaire. L'étape de report des composants microélectroniques sur le support de mise en forme peut alors être effectuée de sorte que les composants microélectroniques reposent et adhérent au niveau d'une zone d'appui de leur face inférieure sur une surface supérieure de parois latérales du support de mise en forme qui entourent les surfaces courbées. Une étape de retrait du substrat poignée peut ensuite être effectuée. Une étape de mise en courbure des composants microélectroniques peut ensuite être effectuée, de sorte qu'ils soient incurvés, et adhérent sur les surfaces courbées par la couche adhésive intercalaire, celle-ci étant alors au contact de la face inférieure de chaque composant microélectronique et de la surface courbée correspondante.

Le procédé peut comporter, avant l'étape de retrait du substrat poignée temporaire assemblé aux composants microélectroniques, une montée en température à une première température comprise dans une gamme de température de réticulation de la couche adhésive intercalaire, puis, pendant ou après l'étape de mise en courbure, une montée en température à une deuxième température comprise dans la gamme de température de réticulation et supérieure à la première température.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B, déjà décrites, sont des vues en coupe, schématiques et partielles, d'un composant microélectronique reporté sur un support de mise en forme, avant (fig. 1A) et après (fig. 1B) sa mise en courbure, par un procédé de mise en courbure collective selon un exemple de l'art antérieur ;
la figure 2A est une vue en coupe, schématique et partielle, d'une structure microélectronique comportant plusieurs composants optiques de type à illumination en face avant (FSI), réalisée au niveau du wafer, dans le cadre d'un procédé de mise en courbure selon un mode de réalisation ;
la figure 2B est une vue en coupe, schématique et partielle, du composant optique illustré sur la fig.2A, alors mis en forme et assemblé à un support de mise en forme et d'interconnexion, dans le cadre d'un procédé de mise en courbure selon un mode de réalisation ;
les figures 3A à 3M illustrent différentes étapes d'un mode de réalisation d'un procédé de mise en forme collective de composants microélectroniques, ici les composants optiques illustrés sur la fig.2A ;
la figure 4 est une vue en coupe, schématique et partielle, de composants optiques identiques à ceux illustrés sur la fig.2A, reportés sur un support de mise en forme selon une variante de réalisation ;
la figure 5A est une vue en coupe, schématique et partielle, d'une structure microélectronique comportant plusieurs composants optiques de type à illumination en face arrière (BSI), réalisée au niveau du wafer, dans le cadre d'un procédé de mise en courbure selon un mode de réalisation ;
la figure 5B est une vue en coupe, schématique et partielle, du composant optique illustré sur la fig.5A, alors mis en forme et assemblé à un support de mise en forme et d'interconnexion, dans le cadre d'un procédé de mise en courbure selon un mode de réalisation ;
les figures 6A à 6C illustrent différentes étapes d'une variante de réalisation du procédé de mise en forme collective de composants microélectroniques, dans laquelle la couche inférieure adhésive est déposée sur les surfaces courbées du support de mise en forme ;
les figures 7A à 7I illustrent différentes étapes d'une variante de réalisation du procédé de mise en forme collective de composants microélectroniques, dans laquelle les composants microélectroniques sont assemblés au même substrat poignée et reportés sur le support de mise en forme.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de mise en courbure collective de composants microélectroniques. Ces derniers sont issus d'un même substrat fonctionnalisé, c'est-à-dire initialement réalisés selon une approche WLP (*Wafer-Level Packaging*, en anglais). Par ailleurs, au terme du procédé de mise en courbure, chaque ensemble formé d'un composant microélectronique assemblé à son support de mise en forme et d'interconnexion électrique présente des dimensions latérales du même ordre que celle du composant microélectronique lui-même. Aussi, le procédé selon l'invention s'inscrit dans la famille des procédés de type WLCSP.

Dans le cas de l'invention, un composant microélectronique comporte un circuit intégré qui peut comporter des éléments microélectroniques actifs tels que des transistors ou des diodes, et/ou des éléments optoélectroniques actifs tels que des diodes électroluminescentes ou des photodétecteurs. Les composants microélectroniques sont réalisés à partir d'un même substrat semiconducteur (ou plaque, *wafer* en anglais).

Dans la suite de la description, les composants microélectroniques sont des composants optiques (mais ils peuvent évidemment être des composants de type hyperfréquence, voire des composants MEMS, entre autres). D'une manière générale, ces derniers peuvent être à transmission optique en face avant (FSI, pour *Front Side Illumination*, en anglais) ou à transmission optique en face arrière (BSI, pour *Back Side Illumination*), selon que le rayonnement lumineux d'intérêt traverse ou non une couche d'interconnexion de type BEOL (pour *Back End of Line*) du composant optique. Cependant, les termes « FSI » et « BSI » sont ici à prendre au sens large : le composant optique peut ainsi être adapté à émettre ou à détecter un rayonnement lumineux d'intérêt. Dans les exemples illustrés par la suite, les composants optiques sont matriciels (mais peuvent ne pas l'être), et comportent chacun une matrice de photodiodes associée à une matrice de microlentilles. Par ailleurs, les composants microélectroniques peuvent être un ensemble formé d'un substrat optique comportant des diodes adaptées à émettre ou recevoir un rayonnement lumineux, et par exemple réalisées à base d'un composé IV, III-V ou II-VI, hybridé à un substrat microélectronique comportant un circuit intégré de commande/lecture des diodes.

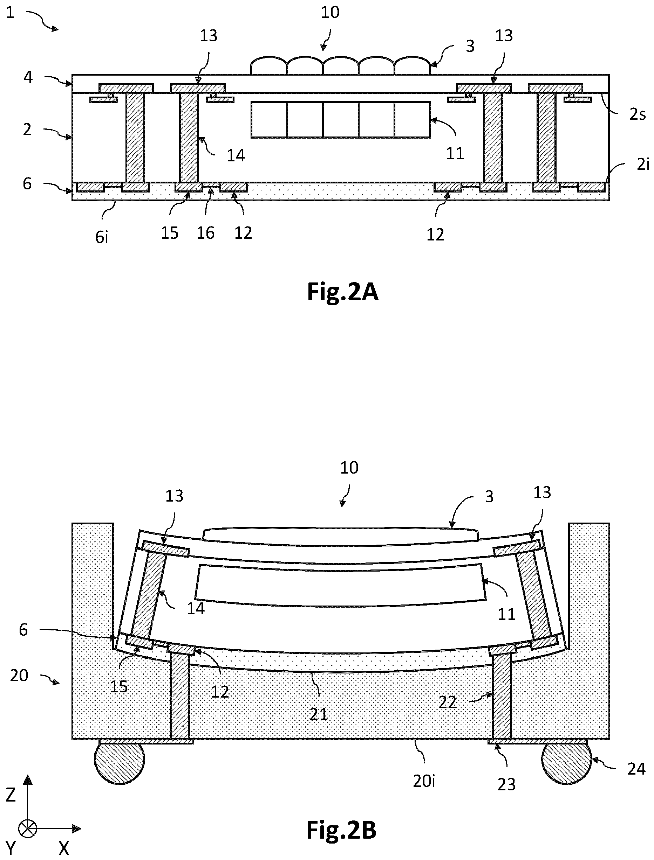

La figure 2A est une vue schématique et partielle, en coupe, d'une structure microélectronique (ici optoélectronique) 1 comportant des composants optiques 10 destinés à être mis en courbure de manière collective par un procédé selon un mode de réalisation de l'invention. Dans cet exemple, les composants optiques 10 présentent une configuration FSI.

On définit ici et pour la suite de la description un repère direct tridimensionnel orthogonal XYZ, où les axes X et Y forment un plan parallèle à la face supérieure d'un substrat optique 2, et où l'axe Z est orienté de la face inférieure 2i à la face supérieure 2s de ce dernier. Dans la suite de la description, les termes « inférieur » et « supérieur » s'entendent comme étant relatifs à un positionnement croissant suivant la direction +Z.

La structure optoélectronique 1 comporte un substrat semiconducteur fonctionnalisé 2, dit substrat optique, une couche inférieure adhésive 6, et ici une matrice de microlentilles 3 assemblée au substrat optique 2 par une couche supérieure isolante 4. La structure optoélectronique 1 est destinée à former une pluralité de composants optiques 10.

Le substrat optique 2 présente une face supérieure 2s destinée ici à recevoir un rayonnement lumineux d'intérêt, et une face inférieure 2i opposée. Il peut présenter une épaisseur de l'ordre de quelques dizaines à une centaine de microns, par exemple une épaisseur comprise entre 20µm et 150µm. Dans cet exemple, les composants optiques 10 sont des imageurs CMOS, le substrat optique 2 étant alors un substrat épais réalisé par exemple à base de silicium. En variante, les composants optiques 10 peuvent être des capteurs CCD.

Le substrat optique 2 comporte, pour chaque composant optique 10, une matrice de photodiodes 11, réalisées par exemple par implantation ionique localisée de dopants dans le silicium du substrat optique 2. Dans cette configuration FSI, une couche d'interconnexion (BEOL) affleure la face supérieure 2s. Elle assure la commande ou la lecture (alimentation) des photodiodes 11. Elle est donc destinée à être connectée électriquement à un circuit électrique externe (non représenté). La couche d'interconnexion comporte des portions de lignes conductrices, par exemple métalliques, séparées les unes des autres par un matériau diélectrique (par exemple un oxyde et/ou nitrure de silicium, selon la longueur d'onde du rayonnement lumineux d'intérêt).

Chaque composant optique 10 comporte ici des plots conducteurs supérieurs 13 reposant sur la face supérieure 2s du substrat optique 2, des plots conducteurs inférieurs 12 reposant sur la face inférieure 2i, des vias conducteurs 14 (ici TSV, pour *Through Silicon Via*, en anglais) connectant les plots conducteurs inférieurs 12 et supérieurs 13. Les plots conducteurs supérieurs 13 sont connectés à la couche d'interconnexion, et les plots conducteurs inférieurs 12 sont connectés chacun aux vias conducteurs 14 ici par l'intermédiaire d'une ligne conductrice 16 et d'un plot conducteur intermédiaire 15. Aussi, la connexion électrique des plots conducteurs inférieurs 12 permet d'assurer les différentes fonctions nécessaires (polarisation, alimentation, traitement des entrées/ sorties, mise à la masse, etc...). En variante, les plots conducteurs inférieurs 12 peuvent être eux-mêmes en contact avec les vias conducteurs 14.

Une couche supérieure isolante 4, réalisée en un matériau diélectrique et transparent au rayonnement lumineux d'intérêt recouvre la face supérieure 2s et contient des lignes conductrices qui débouchent sur les plots 13. Il s'agit d'une couche diélectrique inter-couche (ILD, pour *Inter-Layer Dielectric*). Les plots 13 peuvent être des portions d'une ligne conductrice (ici la dernière ligne conductrice). D'autres agencements de cette dernière sont bien entendu possibles. Par ailleurs, la structure optoélectronique 1 peut également comporter une matrice de filtres colorés, des couches antireflets, ou tout autre élément optique passif.

Une couche inférieure adhésive 6, par exemple une couche de colle polymère, recouvre entièrement la face inférieure 2i ainsi que les plots conducteurs inférieurs 12 (et ici les lignes conductrices 16 et les plots conducteurs intermédiaires 15). Elle présente une face inférieure 6i, plane, libre (c'est-à-dire non revêtue par un autre matériau) et continue. La face inférieure 6i est dite continue dans le sens où elle n'est pas traversée par l'un ou l'autre des plots conducteurs 12, 15. Les plots conducteurs 12, 15 ne sont donc pas en saillie hors de cette couche adhésive inférieure 6. D'un point de vue plus formel, on peut définir une face continue par le fait que deux points quelconques de cette face sont reliés entre eux par un segment dont tous les points appartiennent à la face en question.

La figure 2B est une vue schématique et partielle, en coupe, d'un ensemble obtenu par le procédé selon un mode de réalisation de l'invention, comportant le composant optique 10 illustré sur la fig.2A, incurvé et assemblé à une partie d'un support 20 de mise en forme et d'interconnexion.

Sur cette figure, comme détaillé par la suite, la structure optoélectronique 1 a été préalablement découpée pour individualiser les composants optiques 10. Chaque composant optique 10 a été reporté au contact d'une surface courbée 21 du support 20 de mise en forme et d'interconnexion. La couche inférieure adhésive 6 assure l'assemblage du composant optique 10, alors incurvé, au support de mise en forme 20.

Le support 20 de mise en forme et d'interconnexion présente une double fonction : assurer la mise en courbure collective des composants optiques 10, et établir leur connexion électrique à un circuit électrique externe (non représenté).

Le support de mise en forme 20 comporte une pluralité de surfaces courbées 21 destinées à recevoir les composants optiques 10. Les surfaces courbées 21 sont ici concaves, mais elles peuvent être convexes ou présenter une courbure plus complexe. Elles peuvent présenter des lignes de niveau circulaire ou ovale, ou de toute autre forme. Une ligne de niveau d'une surface courbée 21 est une ligne d'égale distance à la face inférieure 20i du support de mise en forme 20.

De plus, le support de mise en forme 20 comporte des interconnexions électriques assurant la connexion électrique entre les plots conducteurs inférieurs 12 et des éléments de connexion externe 24, ici des billes en un matériau fusible, par exemple de l'indium ou un alliage à base de SnAg. Il comporte pour cela des vias conducteurs 22 s'étendant au travers du support de mise en forme 20 et de la couche inférieure adhésive 6, à partir de la face inférieure 20i, jusqu'aux plots conducteurs inférieurs 12. Il peut comporter également des lignes conductrices 23 s'étendant sur la face inférieure 20i et reliant chacune une extrémité d'un via conducteur 22 à une bille d'indium 24.

Le support de mise en forme 20 peut être réalisé en un même matériau, ou être formé de plusieurs matériaux différents. Le ou les matériaux sont électriquement isolants. Le support 20 peut être monobloc, ou être formé de plusieurs blocs ou couches épaisses rapportées et assemblées les unes aux autres, par exemple une couche épaisse plane surmontée d'une couche structurée. Dans cet exemple, le support de mise en forme 20 est réalisé en un même matériau, par exemple du silicium.

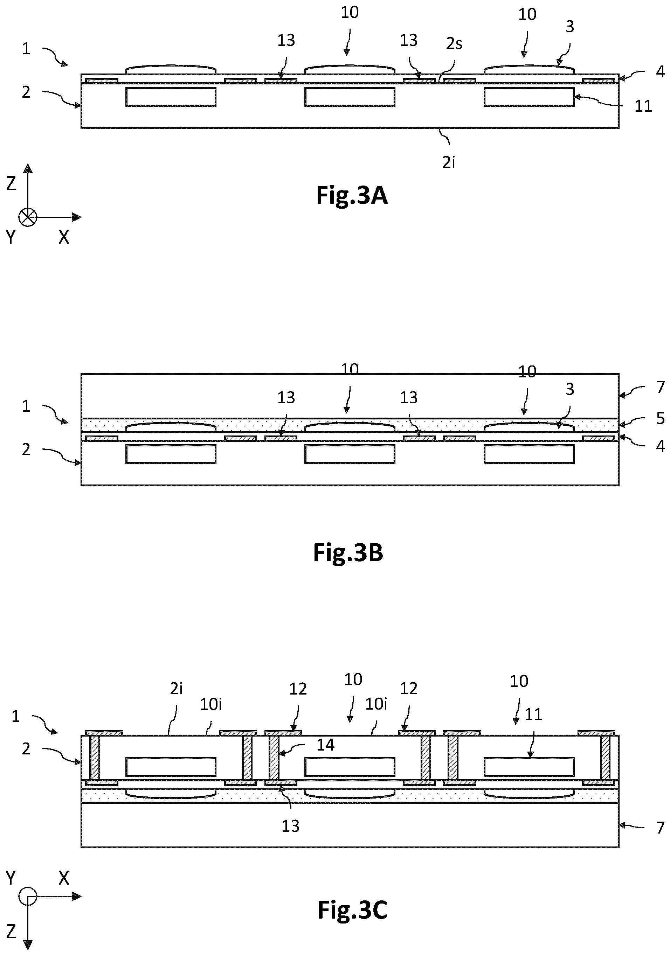

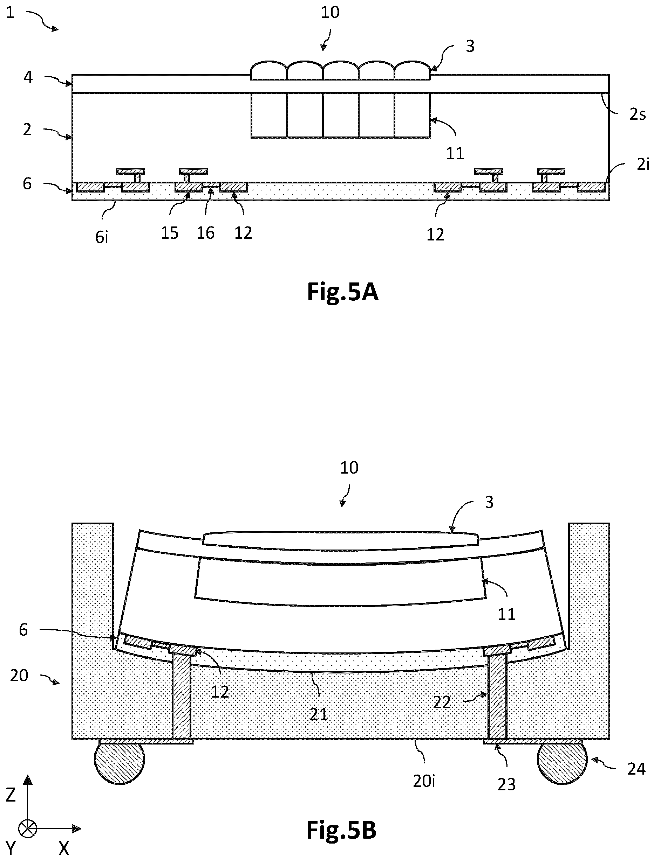

Les figures 3A à 3M illustrent différentes étapes du procédé de mise en courbure collective de composants optiques 10 similaires à ceux illustrés sur les fig.2A et 2B, selon un mode de réalisation. Les matrices de photodiodes 11 et de microlentilles 3 sont représentées de manière simplifiée (comme sur la fig.2B), ceci pour privilégier la clarté des figures. Dans cet exemple, les composants optiques 10 sont donc de type FSI, mais une configuration BSI est également possible (cf. les fig.5A et 5B).

En référence à la fig.3A, on réalise la structure microélectronique (ici optoélectronique) 1. Il s'agit ici d'une réalisation de type *wafer-level*, dans le sens où une pluralité de composants optiques 10 identiques est réalisée dans le même substrat semiconducteur alors fonctionnalisé (ou substrat optique) 2. Chaque composant optique 10 comporte ici une matrice de photodiodes 11 réalisées dans le substrat semiconducteur 2. Ce dernier est ici réalisé en silicium. Des plots conducteurs supérieurs 13 sont disposés ici sur la face supérieure 2s et sont reliés à la couche d'interconnexion (non représentée) assurant la connexion électrique des photodiodes 11. La face supérieure 2s est ici recouverte par une couche supérieure isolante 4. Cette couche supérieure isolante 4 recouvre les plots conducteurs supérieurs 13.

En référence à la fig.3B, on dépose une couche supérieure adhésive 5, de manière à recouvrir le substrat optique 2. Dans cet exemple, cette couche 5 s'étend sur et au contact de la couche supérieure isolante 4 et des microlentilles 3. Elle présente une face supérieure plane. Cette couche adhésive peut être temporaire, par exemple pour assurer seulement l'assemblage d'un substrat poignée temporaire 7 permettant l'amincissement du substrat optique 2, puis la manipulation des composants optiques 10. Elle peut être réalisée en un matériau thermoplastique, tel que le matériau HT1010 commercialisé par la société Brewer Science. Ensuite, on assemble le substrat poignée 7 à la face libre de la couche supérieure adhésive 5. Le substrat poignée 7 est un substrat rigide, réalisé par exemple en silicium ou en verre.

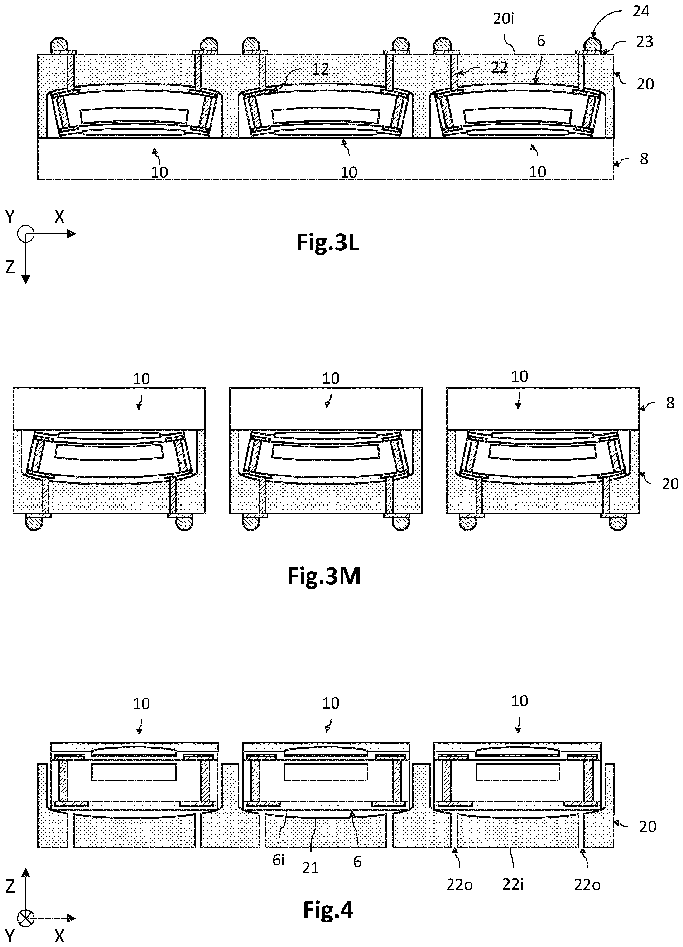

En référence à la fig.3C, l'empilement ainsi obtenu est retourné, puis on effectue un amincissement du substrat optique 2 à partir de sa face inférieure 2i, par exemple par polissage mécanique en présence ou non d'une solution contenant des particules abrasives, puis avec une finition par polissage mécano-chimique, attaque chimique, gravure plasma fluorée, ou autre. Le substrat optique 2 présente alors une épaisseur finale de l'ordre de 20µm à 150µm, ce qui autorise une mise en courbure des composants optiques 10 tout en préservant leurs propriétés mécaniques.

On réalise ensuite les interconnexions électriques permettant d'établir une connexion électrique des matrices de photodiodes 11 des composants optiques 10. Auparavant, un amincissement du substrat optique 2, à partir de sa face inférieure 2i, est réalisé, par exemple par polissage mécanique en présence ou non d'une solution contenant des particules abrasives, puis avec une finition par polissage mécano-chimique, attaque chimique, gravure plasma fluorée, ou autre. Le substrat optique 2 présente alors une épaisseur finale de l'ordre de 20µm à 150µm, ce qui autorise une mise en courbure des composants optiques 10 tout en préservant leurs propriétés mécaniques.

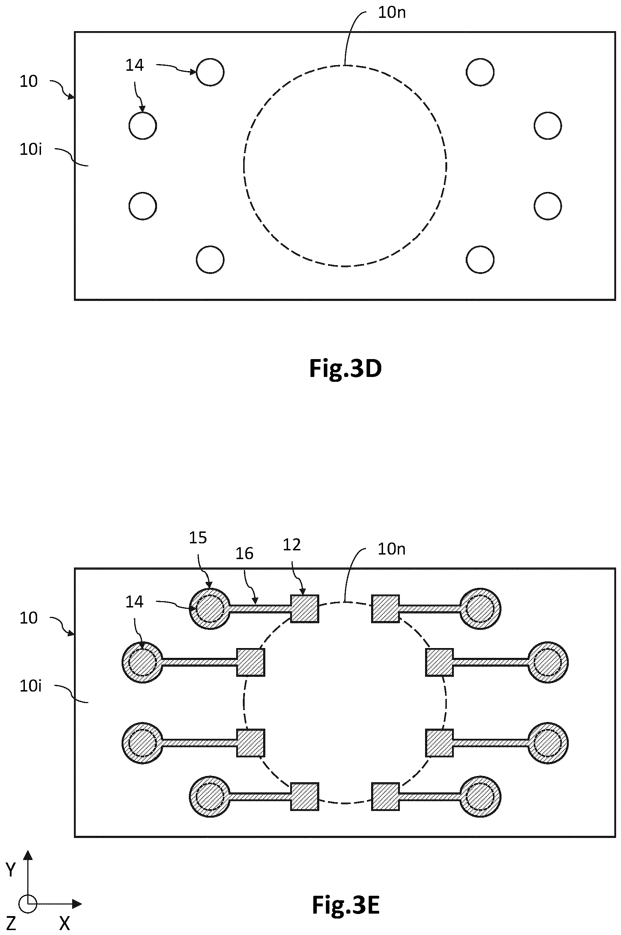

On réalise ensuite des vias conducteurs 14, s'étendant au travers du substrat optique 2 à partir de la face inférieure 2i jusqu'à déboucher sur les plots conducteurs supérieurs 13. On réalise ensuite les plots conducteurs inférieurs 12 sur la face inférieure 2i, ainsi que, dans cet exemple, des plots conducteurs intermédiaires 15 situés au contact des vias conducteurs 14, et des lignes conductrices 16 reliant les plots conducteurs inférieurs 12 aux plots conducteurs intermédiaires 15 (les plots conducteurs intermédiaires 15 et les lignes conductrices 16 sont illustrés sur la fig.3E). Les plots conducteurs 12, 15 peuvent être réalisés en un ou plusieurs matériaux électriquement conducteurs, par exemple métalliques. Comme détaillé sur la fig.3E, les plots conducteurs inférieurs 12 sont ici avantageusement agencés le long d'une ligne de niveau de la face inférieure 10i de chaque composant optique 10 (la face inférieure 10i est identique à la face inférieure 2i). Une ligne de niveau 10n de la face inférieure 10i est définie comme étant, lorsque le composant optique 10 est assemblé au support de mise en forme 20 et incurvé selon la courbure de la surface courbée 21, une ligne d'égale distance à la face inférieure 20i du support de mise en forme 20.

La fig.3D illustre ainsi la face inférieure 10i de l'un des composants optiques 10. Y sont représentés les orifices inférieurs des vias conducteurs 14. Ils sont ici agencés autour et à l'extérieur d'une ligne de niveau (trait pointillé) du composant optique 10. Cette ligne de niveau 10n a été prédéterminée en fonction de la position et de la courbure que le composant optique 10 est destiné à avoir lorsqu'il sera assemblé au support de mise en forme 20. Dans cet exemple, la ligne de niveau 10n est circulaire, mais elle pourrait présenter une autre forme.

La fig.3E illustre la même face inférieure 10i du composant optique 10, sur laquelle ont été réalisés les plots conducteurs inférieurs 12, les lignes conductrices 16 et les plots conducteurs intermédiaires 15. Les plots conducteurs intermédiaires 15 sont situés au contact des vias conducteurs 14. Les plots conducteurs inférieurs 12 sont situés sur la ligne de niveau 10n. Les lignes conductrices 16 relient les plots conducteurs intermédiaires 15 aux plots conducteurs inférieurs 12.

Le fait que les plots conducteurs inférieurs 12 soient avantageusement situés le long de la ligne de niveau 10n permet de réaliser les vias conducteurs 22 du support de mise en forme 20 après l'assemblage du composant optique 10 au support de mise en forme 20, et non pas avant cette étape, de sorte qu'ils présentent tous une dimension verticale uniforme, c'est-à-dire la même hauteur, sans risquer de dégrader les composants optiques 10.

Notons que cet agencement des plots conducteurs intermédiaires 15 et des plots conducteurs inférieurs 12 est donné à titre illustratif. D'autres agencements sont possibles. Ainsi, les interconnexions électriques peuvent ne pas comporter les lignes conductrices 16. Les vias conducteurs 14 du composant optique 10 peuvent donc déboucher directement sur les plots conducteurs inférieurs 12, lesquels s'étendent donc de manière à être au moins en partie situés sur la ligne de niveau.

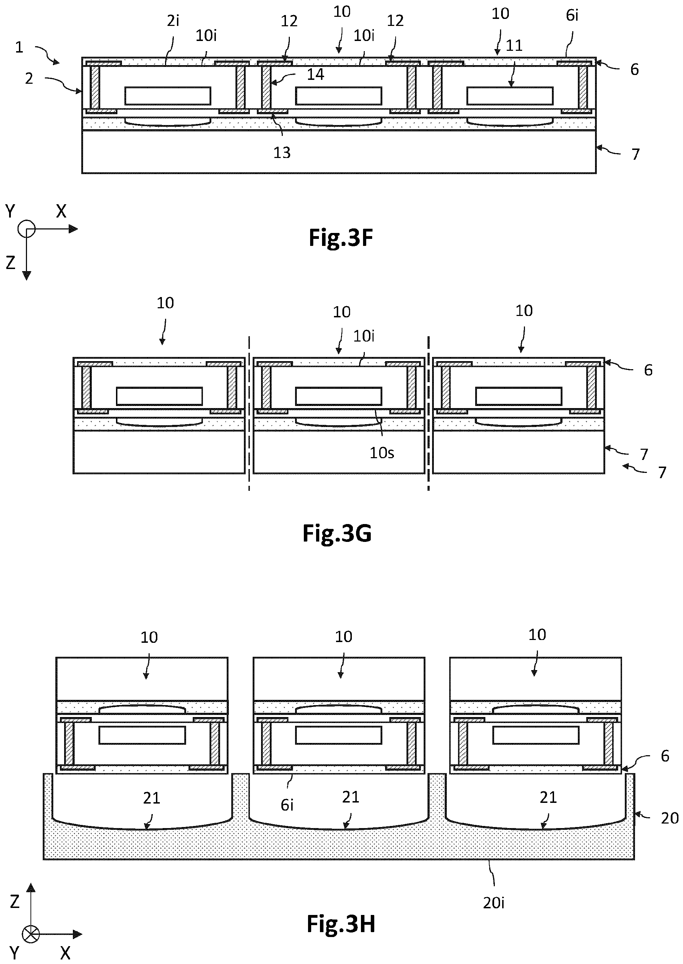

En référence à la fig.3F, la face inférieure 2i du substrat optique 2 est recouverte entièrement par une couche inférieure adhésive 6. Celle-ci recouvre donc également entièrement les lignes conductrices 16 et les plots conducteurs inférieurs 12 et intermédiaires 15. En effet, la couche inférieure adhésive 6 présente une épaisseur supérieure à celle des plots conducteurs inférieurs 12 (et le cas échéant, comme ici, des lignes 16 et plots 15). Sa face inférieure 6i est alors continue, et n'est donc pas traversée par les plots conducteurs intermédiaires 15 et inférieurs 12 qui seraient alors en saillie hors de cette couche 6. Elle est une couche adhésive permanente, dans la mesure où elle va assurer l'assemblage des composants optiques 10 aux surfaces courbées 21 du support de mise en forme 20. La couche inférieure adhésive 6 peut être une colle époxy, par exemple bi-composant. Elle peut être choisie parmi les colles H20S, H20E, H70S de la marque EPO-TEK. Il peut également s'agir des colles Araldite 2011, Loctite Hysol KO111, Loctite Ablestik QMI516, Kyocera CT285-2 et Kyocera CT285-F, Creative Material 118-06F et 122-07(SP)... entre autres.

A la différence du document US2009/0115875A1 cité précédemment, les plots conducteurs inférieurs 12 ne font pas saillie vis-à-vis de la couche inférieure adhésive 6, et il n'est donc pas nécessaire qu'ils soient déformés pour assurer la mise en courbure du composant optique 10 et son collage sur la surface courbée 21. Cela se traduit par le fait que la courbure effective du composant optique 10 est alors aussi proche que possible de la courbure voulue (définie par celle de la surface courbée 21).

En référence à la fig.3G, on découpe l'empilement obtenu de manière à individualiser les composants optiques 10, suivant des lignes de découpe prédéfinies. On obtient ainsi une pluralité de composants optiques 10, distincts les uns des autres, assemblés chacun à une partie du substrat poignée 7 au niveau de leur face supérieure 10s, et comportant une portion de la couche inférieure adhésive 6 au niveau de leur face inférieure 10i. La présence du substrat poignée 7 permet de manipuler et de diviser l'empilement obtenu sans risques mécaniques pour les composants optiques 10.

En référence à la fig.3H, on reporte les composants optiques 10 en regard des surfaces courbées 21 du même support de mise en forme 20. Cette étape peut être réalisée de manière collective, ou composant optique par composant optique.

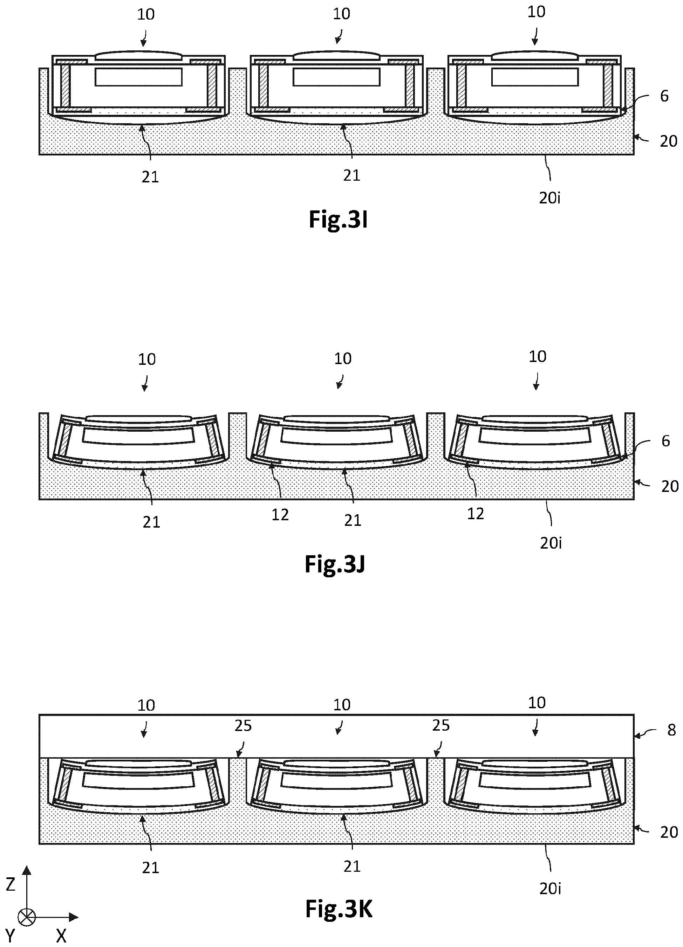

Dans cet exemple, le support de mise en forme 20 comporte donc une pluralité de surfaces courbées 21, ici de forme concave, lesquelles sont séparées deux à deux par des espaceurs ayant la forme de parois latérales 25 destinées à permettre ultérieurement l'assemblage d'un deuxième substrat poignée 8 (cf. fig.3K). Il comporte une face inférieure plane 20i, opposée aux surfaces courbées 21. Dans cet exemple, le support de mise en forme 20 est réalisé en un même bloc et en un même matériau, par exemple ici en silicium. Il peut être réalisé en un matériau thermiquement conducteur pour autoriser une meilleure évacuation de la chaleur produite par les composants optiques 10 en fonctionnement.

A cette étape du procédé, à la différence du document US2009/0115875A1 cité précédemment, le support de mise en forme 20 n'est pas traversé par les vias conducteurs 22 qui déboucheraient au niveau des surfaces courbées 21. Comme l'illustre la fig.4, des orifices traversants 22o peuvent toutefois être déjà réalisés. Cependant, ils ne sont pas encore remplis d'un matériau conducteur, et peuvent alors participer à la mise en courbure des composants optiques 10 par aspiration du gaz présent dans l'espace situé entre la face inférieure de la couche inférieure adhésive 6 et la surface courbée 21. Notons que le support de mise en forme 20 peut également comporter des orifices traversants situés au centre des surfaces courbées 21, ces orifices traversants pouvant être identiques ou similaires à ceux décrits dans le document US2009/0115875A1.

En référence à la fig.3I, les composants optiques 10 sont mis au contact du support de mise en forme 20. Ainsi, une partie de la couche inférieure adhésive 6 vient localement au contact d'une partie périphérique de la surface courbée 21. La mise en forme n'est pas encore effectuée à cette étape. Ensuite, le substrat poignée 7 est retiré de chaque composant optique 10, ceci par un traitement thermique, chimique ou mécanique. La couche supérieure adhésive 5 peut également être retirée.

En référence à la fig.3J, les composants optiques 10 sont mis en forme de manière collective, de sorte que la couche inférieure adhésive 6 vienne au contact de la surface courbée 21. Pour cela, on applique une pression à chacun des composants optiques 10, par exemple par un outil de presse (non représenté) ou par une technique décrite dans le document EP3480850A1, de manière simultanée. Une montée en température peut également être effectuée, au minimum à la température de polymérisation de la colle, le cas échéant. Chaque composant optique 10 se déforme et prend la courbure imposée par la surface courbée 21 correspondante. On obtient ainsi une pluralité de composants optiques 10, tous incurvés suivant la courbure voulue, assemblés au même support de mise en forme 20.

Notons ici que la couche inférieure adhésive 6 n'est pas traversée par les plots conducteurs inférieurs 12 et intermédiaires 15 qui seraient en saillie. La mise en forme n'est alors pas perturbée par de tels plots en saillie, de sorte que les composants optiques 10 peuvent alors présenter une courbure qui est la courbure voulue (celle des surfaces courbées 21).

En référence à la fig.3K, on assemble à l'empilement ainsi obtenu un substrat poignée 8, permettant de le manipuler lors de l'étape de réalisation des interconnexions électriques dans le support de mise en forme 20. Pour cela, le substrat poignée 8 est assemblée à l'extrémité libre des parois latérales 25. Une couche de colle (non représentée) peut être utilisée à cette étape. Le substrat poignée 8 peut être une poignée temporaire (par exemple réalisée en silicium), notamment lorsqu'il n'est pas transparent au rayonnement lumineux d'intérêt, ou peut être une poignée permanente (par exemple réalisée en verre) et servir de capot transparent de protection vis-à-vis de chaque composant optique 10.

En référence à la fig.3L, l'empilement obtenu est retourné, et on réalise les interconnexions électriques dans le support de mise en forme 20. Celles-ci permettent d'établir la connexion électrique entre un circuit électrique externe (non représenté) et les matrices de photodiodes, via les interconnexions électriques de chaque composant optique 10.

Ainsi, on réalise des vias conducteurs 22 qui s'étendent au travers du support de mise en forme 20 et de la couche inférieure adhésive 6, à partir de la face inférieure 20i, jusqu'à déboucher directement sur les plots conducteurs inférieurs 12. Pour cela, on réalise les orifices traversants de manière simultanée de sorte qu'ils présentent tous une même hauteur. Dans la mesure où ils débouchent sur les plots conducteurs inférieurs 12, lesquels sont situés sur les lignes de niveau des faces inférieures 10i alors incurvées suivant la courbure imposée par celle des surfaces courbées 21, il n'y a pas de risque que la réalisation des orifices traversants ne dégrade les composants optiques 10. On réalise ensuite les vias conducteurs 22 par remplissage au moins partiel des orifices traversants par un matériau électriquement conducteur.

Les interconnexions électriques du support de mise en forme 20 peuvent également comporter, comme illustré dans cet exemple, des lignes conductrices 23 s'étendant sur la face inférieure 20i. On peut également réaliser des éléments de connexion 24 à un circuit électrique externe (non représenté), par exemple situé dans un circuit imprimé PCB (pour *Printed Circuit Board*, en anglais). Il s'agit ici de billes en un matériau fusible tel que de l'indium.

En référence à la fig.3M, on découpe l'empilement ainsi obtenu pour individualiser les composants optiques 10. Dans cet exemple, le substrat poignée 8 forme un capot permanent dans la mesure où il est réalisé en un matériau transparent au rayonnement lumineux d'intérêt. En variante, il peut être retiré, avant ou après cette opération de découpe. Un capot transparent peut ou non être assemblé aux différents composants optiques 10.

Ainsi, le procédé de mise en courbure collective permet d'obtenir une pluralité de composants optiques 10 incurvés et assemblés à une partie d'un même support 20 de mise en forme et d'interconnexion électrique. Dans la mesure où la couche inférieure adhésive 6 présente une épaisseur supérieure à celles des plots conducteurs 12 (et le cas échéant des lignes 16 et plots 15), sa face inférieure 6i est continue (donc sans que les plots conducteurs ne soient en saillie), les composants optiques 10 peuvent effectivement présenter la courbure voulue. De plus, les vias conducteurs 22 sont réalisés après mise en courbure et assemblage, et présentent avantageusement la même hauteur. Pour assurer une bonne connexion électrique sans risquer de dégrader les composants optiques, ils viennent déboucher sur les plots conducteurs inférieurs 12, lesquels sont alors avantageusement situés sur une ligne de niveau de la face inférieure 10i incurvée des composants optiques 10.

La figure 4 est une vue schématique et partielle, en coupe, d'une étape d'un procédé de mise en courbure collective selon une variante de réalisation.

Ici, les orifices traversants 22o des vias conducteurs 22 sont réalisés dans le support de mise en forme 20 avant l'étape de report et d'assemblage des composants optiques 10. Ainsi, les orifices traversants 22o s'étendent au travers du support de mise en forme 20, à partir de la face inférieure 20i jusqu'aux surfaces courbées 21. Aussi, ces orifices traversants 22o peuvent être mis à contribution lors de la mise en courbure des composants optiques 10. Pour cela, le gaz situé dans l'espace délimité par la face inférieure 6i de la couche inférieure adhésive 6 et de la surface courbée 21 est aspiré pour aider à la mise en courbure des composants optiques 10.

Comme indiqué précédemment, le support de mise en forme 20 peut comporter au moins un orifice traversant supplémentaire (non représenté), situé par exemple au centre de chaque surface courbée.

Le procédé de mise en courbure collective comporte alors, après la mise en courbure des composants optiques 10 et leur assemblage aux différentes surfaces courbées 21, une étape dans laquelle les orifices traversants 22o sont agrandis pour traverser la couche inférieure adhésive 6 et ainsi déboucher sur les plots conducteurs inférieurs 12. Ils peuvent ensuite être remplis par un matériau électriquement conducteur, pour ainsi obtenir les vias conducteurs 22.

La figure 5A est une vue schématique et partielle, en coupe, d'une structure optoélectronique 1 comportant des composants optiques 10 destinés à être mis en courbure de manière collective par un procédé selon un mode de réalisation de l'invention. Dans cet exemple, les composants optiques 10 présentent une configuration BSI.

La structure optoélectronique 1 est similaire à celle décrite précédemment en référence à la fig.2A, et en diffère en ce que la couche d'interconnexion (BEOL) affleure la face inférieure 2i et non pas la face supérieure 2s du substrat optique 2. Aussi, la structure optoélectronique 1 comporte ici, pour chaque composant optique 10, des seuls plots conducteurs inférieurs 12 (assurant la connexion à la matrice de photodiodes via la couche d'interconnexion), et non pas des plots conducteurs supérieurs 13. Il n'y a donc pas ici de vias conducteurs 14 traversant le substrat optique 2.

La figure 5B est une vue schématique et partielle, en coupe, d'un ensemble obtenu par le procédé selon un mode de réalisation de l'invention, comportant le composant optique 10 illustré sur la fig.5A, incurvé et assemblé à une partie du support 20 de mise en forme et d'interconnexion électrique. Le support de mise en forme 20 est ici identique à celui décrit précédemment, et n'est donc pas détaillé à nouveau.

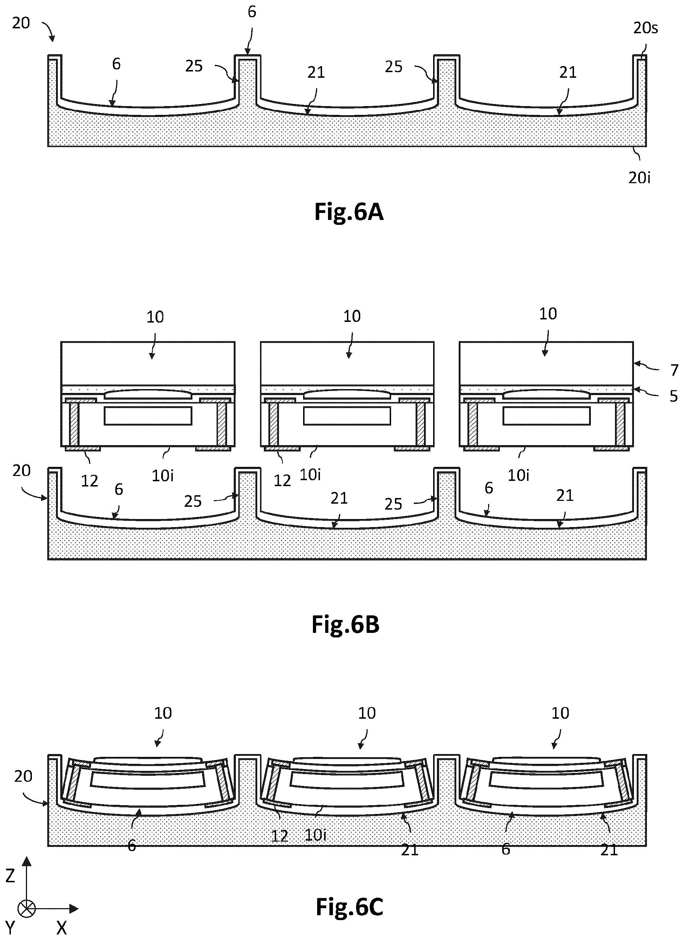

Les figures 6A à 6C illustrent différentes étapes d'un procédé de mise en courbure collective selon une variante de réalisation. Le procédé se distingue ici de celui illustré sur les fig.3A à 3M essentiellement en ce que la couche inférieure adhésive 6 est déposée sur la face supérieure 20s du substrat de mise en forme 20 et non pas sur la face inférieure 2i du substrat optique 2.

Quoi qu'il en soit, la couche inférieure adhésive 6 présente une épaisseur supérieure à celle des plots conducteurs inférieurs 12. Aussi, lors de la mise en courbure des composants optiques 10, ces derniers ne « percent » donc pas la couche inférieure adhésive 6, de sorte que la courbure effective des composants optiques 10 alors incurvés peut correspondre à la courbure voulue.

La fig.6A illustre l'étape de dépôt de la couche inférieure adhésive 6 sur la face supérieure 20s du support de mise en forme 20. Elle présente une épaisseur de préférence uniforme sur les surfaces courbées 21 et sur la surface supérieure des parois latérales 25. A titre illustratif, l'épaisseur peut être comprise entre 5µm et 100µm, et être par exemple égale à 60µm environ. La couche adhésive intercalaire 6 peut être déposée par centrifugation (*spin coating* en anglais), par spray, sérigraphie, laminage d'un film sec, entre autres.

La fig.6B illustre l'étape de report des composants optiques 10 en regard des surfaces courbées 21 du même support de mise en forme 20. Cette étape est identique ou similaire à celle décrite précédemment en référence à la fig.3H.

La fig.6C illustre l'étape de mise en contact et de mise en forme des composants optiques 10 sur le support de mise en forme 20. Cette étape est identique ou similaire à celles décrites précédemment en référence aux fig.3I et 3J. On met tout d'abord en contact chaque composant optique 10 sur la couche inférieure adhésive 6, et on retire les parties du substrat poignée 7 (et la couche supérieure adhésive 5). On met ensuite en forme les composants optiques 10 de manière collective, de sorte que la face inférieure 10i et les plots conducteurs inférieurs 12 viennent au contact de la couche inférieure adhésive 6. Chaque composant optique 10 se déforme et prend la courbure imposée par la surface courbée 21 correspondante. On obtient ainsi une pluralité de composants optiques 10, tous incurvés suivant la courbure voulue, assemblés au même support de mise en forme 20.

Dans la mesure où la couche inférieure adhésive 6 présente une épaisseur supérieure à celle des plots conducteurs inférieurs 12, les plots conducteurs 12 ne « percent » pas la couche inférieure adhésive 6 pour venir au contact direct des surfaces courbées 21, les composants optiques 10 peuvent donc présenter effectivement la courbure voulue. Le procédé de mise en courbure peut ensuite se poursuivre avec les étapes de structuration du support de mise en forme 20, comme décrit notamment en référence aux fig.3K à 3M.

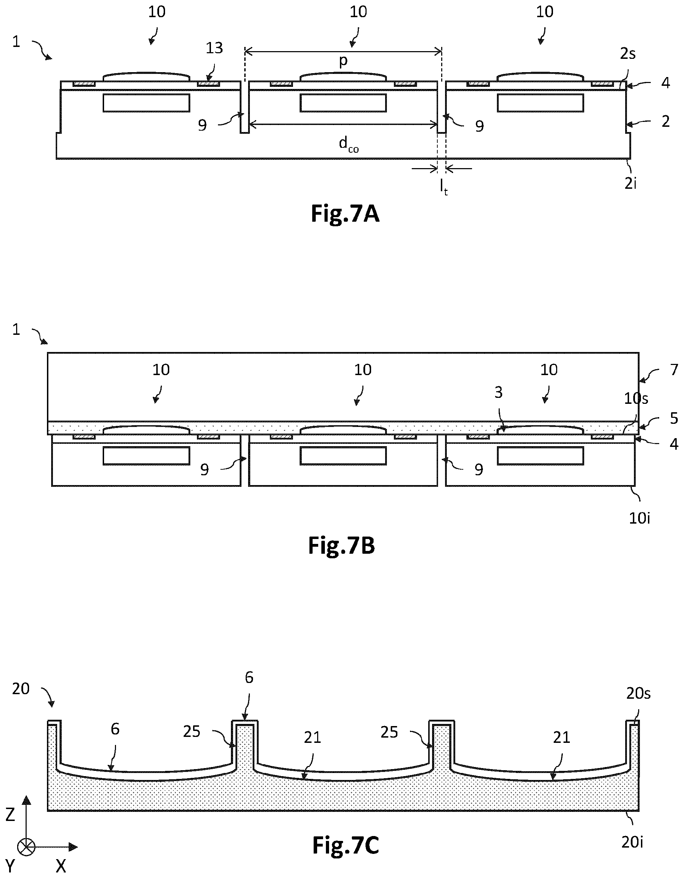

Les figures 7A à 7I illustrent différentes étapes d'un procédé de mise en courbure collective selon une autre variante de réalisation. Le procédé se distingue ici de celui illustré sur les fig.6A à 6C essentiellement en ce que les composants optiques 10 sont reportés sur le support de mise en forme 20 de manière collective, alors qu'ils sont tous assemblés au même substrat poignée 7.

La fig.7A illustre la réalisation de la structure initiale 1 comportant un substrat semiconducteur fonctionnalisé 2, ici le substrat optique. La structure initiale 1 comporte également la matrice de microlentilles 3, assemblée au substrat optique 2 par une couche supérieure isolante 4. La structure initiale 1 comporte une pluralité de composants optiques 10, destinés à être individualisés.

En référence à la fig.7B, on réalise des tranchées 9 dans la structure initiale 1, de manière à pré-individualiser les composants optiques 10, à partir de leur face supérieure. Cette étape peut être effectuée par sciage mécanique ou par gravure laser, de manière à traverser la couche supérieure isolante 4 et à s'étendre suivant une partie de l'épaisseur du substrat optique 2. Les tranchées 9 sont des échancrures non traversantes qui ne débouchent pas sur la face inférieure 2i. Les tranchées 9 entourent les composants optiques 10 et s'étendent sur une profondeur qui définit l'épaisseur finale du substrat optique 2, par exemple ici sur une profondeur de l'ordre de 20µm à 150µm. Elles présentent une largeur lₜ dans le plan XY et s'étendent de manière longitudinale de manière à définir la forme des composants optiques 10 dans le plan XY. Cette forme peut être polygonale, par exemple carrée ou rectangulaire, voire circulaire ou ovale. Dans cet exemple, les composants optiques 10 présentent une forme carrée dans le plan XY de côté d_{co}. Les tranchées 9 sont espacées les unes des autres de manière régulière au pas p.

On assemble le substrat optique 2 au substrat poignée 7 temporaire, du côté de la face supérieure 2s. Le substrat poignée 7 est réalisé dans un matériau rigide, réalisé par exemple en verre ou en silicium. On dépose ici une couche adhésive supérieure 5, de manière à recouvrir le substrat optique 2, puis on assemble le substrat poignée 7.

On réalise ensuite un amincissement du substrat optique 2, à partir de sa face inférieure 2i, par exemple par polissage mécanique en présence ou non d'une solution contenant des particules abrasives, puis avec une finition par polissage mécano-chimique, attaque chimique, gravure plasma fluorée, ou autre. Le substrat optique 2 présente alors une épaisseur finale de l'ordre de 20µm à 150µm, ce qui autorise une mise en courbure des composants optiques 10 tout en préservant leurs propriétés mécaniques. L'amincissement est effectué jusqu'à rendre traversantes les tranchées 9. On obtient ainsi une même structure dans laquelle les composants optiques 10 sont séparés et distants les uns des autres de la distance lt, tout en étant tous assemblés au substrat poignée 7. On réalise ensuite les vias conducteurs 14 et les plots inférieurs 12 (et lignes 16 et plots 15 le cas échéant), comme décrit précédemment (cf. fig.3C par ex.).

La fig.7C illustre l'étape de dépôt de la couche adhésive intercalaire 6 sur la face supérieure 20s du support de mise en forme 20. Elle présente une épaisseur de préférence uniforme sur les surfaces courbées 21. A titre illustratif, l'épaisseur peut être comprise entre 5µm et 100µm, et être par exemple égale à 60µm environ. Cette épaisseur est toutefois supérieure à l'épaisseur des plots conducteurs inférieurs 12.

La couche adhésive intercalaire 6 peut s'agir d'une colle polymère dont la réticulation présente une plage de température importante, par exemple comprise entre 80°C et 200°C. Il est donc possible de procéder à sa réticulation en deux temps, c'est-à-dire d'obtenir une première réticulation, partielle, permettant d'assurer le maintien des composants optiques 10 sur les parois latérales 25 lors de l'étape de retrait du substrat poignée 7 tout en autorisant ensuite la mise en courbure collective de ces derniers, puis d'effectuer une deuxième réticulation, totale ou quasi-totale, permettant alors d'assurer le maintien des composants optiques 10 alors situés au niveau des surfaces courbées 21. Une telle colle peut être, à titre d'exemple, la colle Furukawa AFN-601-60M.

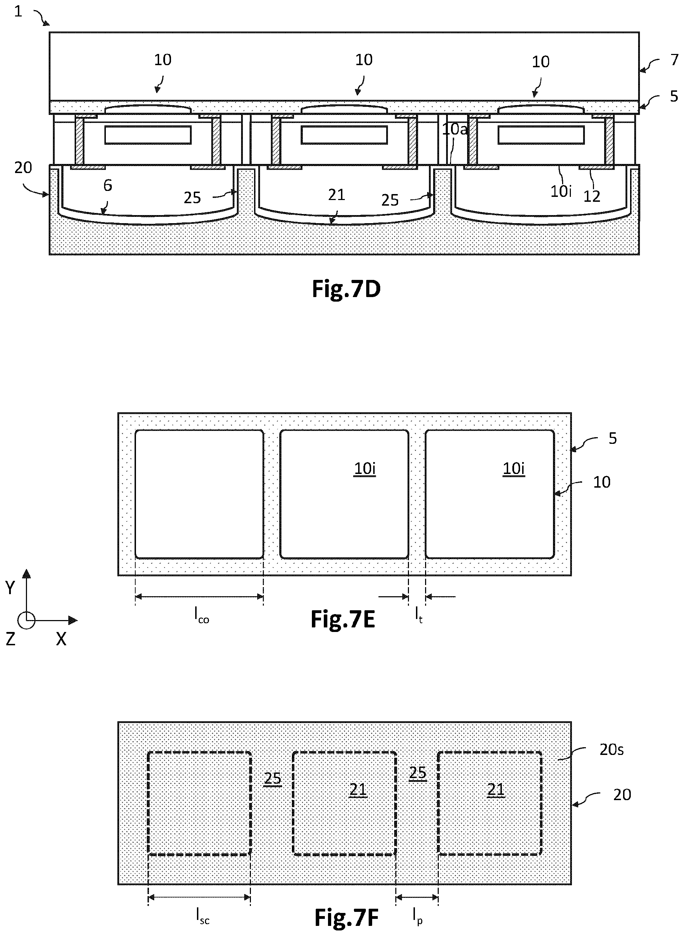

En référence à la fig.7D, on reporte de la structure obtenue lors de l'étape 7B sur le support de mise en forme 20, de sorte que les composants optiques 10 reposent sur les parois latérales 25. Plus précisément, les composants optiques 10 reposent sur les parois latérales 25 au niveau d'une zone périphérique de leur face inférieure 10i, définissant une zone d'appui 10a. La largeur de cette zone d'appui 10a, pour chaque composant optique 10, est égale à la moitié de la différence entre la largeur lₚ des parois latérales 25 et la largeur lₜ des tranchées 9 : c'est-à-dire à (lₚ-lₜ)/2.

La fig.7E illustre la face inférieure 10i des composants optiques 10, séparés les uns des autres de la distance lt, ainsi que la face inférieure de la couche adhésive supérieure 5. Dans cet exemple, les composants optiques 10 présentent une forme carrée dans le plan XY, de côté l_{co}.

La fig.7F illustre la face supérieure 20s du support de mise en forme 20. Dans cet exemple, les surfaces courbées 21 présentent une forme carrée dans le plan XY de côté l_{sc}, et un rayon de courbure R_{c} mesuré ici suivant les axes X et Y. Le côté l_{sc} est inférieur au côté l_{co}. De plus, les parois latérales 25 présentent une largeur lₚ supérieure à la largeur lt des tranchées 9.

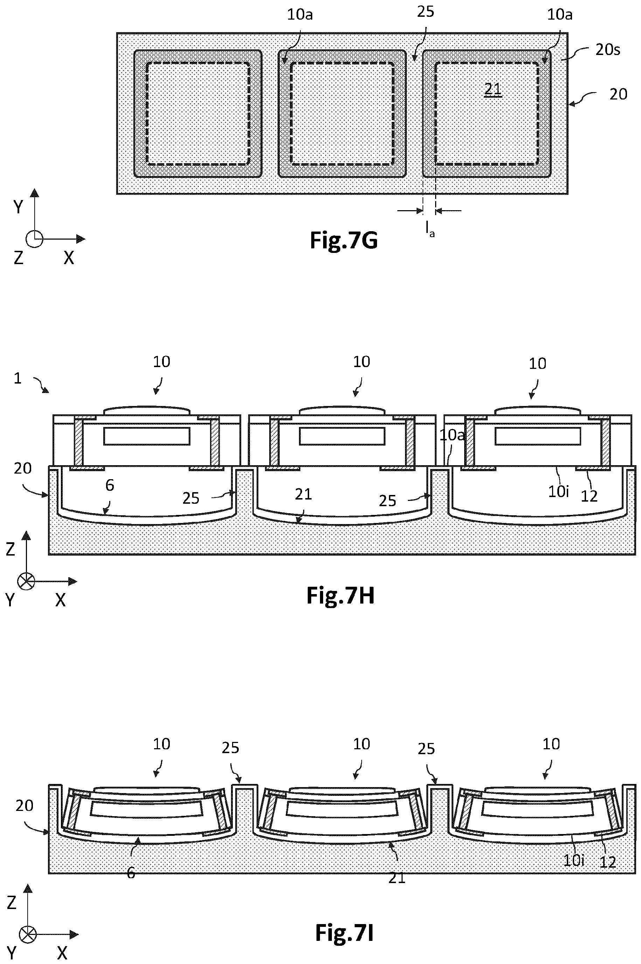

La fig.7G illustre la face supérieure 20s du support de mise en forme 20 sur lequel les composants optiques 10 ont été reportés, mettant en évidence la zone d'appui 10a de ces derniers sur les parois latérales 25. La zone d'appui 10a présente une largeur d'appui lₐ non nulle égale à (lₚ-lₜ)/2.

Le procédé peut en effet comporter une étape préalable de dimensionnement des composants optiques 10 et du support de mise en forme 20, de sorte que les composants optiques 10 présentent une largeur d'appui lₐ suffisante lors de l'étape de retrait du substrat poignée 7, tout en étant en mesure d'être incurvés pour venir contre les surfaces courbées 21. On peut ainsi déterminer une évolution de la largeur d'appui maximale l_{a,max} de chaque composant optique 10 sur une paroi latérale 25 en fonction du rayon de courbure R_{c} de la surface courbée 21. Ce modèle géométrique permet de déduire, à partir de la largeur l_{co} des composants optiques 10 et du rayon de courbure R_{c}, la largeur d'appui maximale l_{a,max} des composants optiques 10 pour qu'ils puissent être incurvés selon le rayon de courbure R_{c} et venir contre les surfaces courbées 21.

Par ailleurs, on considère que la largeur d'appui lₐ sera de préférence supérieure ou égale à une valeur limite l_{a,min}, par exemple égale à 10µm, en deçà de laquelle la largeur d'appui lₐ ne sera pas suffisante pour assurer le maintien des composants optiques 10. De plus, on considère que le rayon de courbure R_{c} sera supérieur ou égal à une valeur limite R_{c,min}, par exemple égale à 70mm, de manière à éviter toute dégradation des propriétés mécaniques des composants optiques 10 alors incurvés et présentant le rayon de courbure R_{c}. Les valeurs limites l_{a,min} et R_{c,min} peuvent bien entendu être déterminées au cas par cas.

Aussi, connaissant le rayon de courbure R_{c} voulu et la dimension transversale lₐ des composants optiques 10, il est possible de déterminer une largeur d'appui lₐ comprise entre une valeur minimale l_{a,min} prédéfinie et une valeur maximale l_{a,max} déterminée à partir du modèle géométrique, de sorte que les composants optiques 10 reposent suffisamment sur les parois latérales 25, tout en pouvant ensuite être incurvés suivant le rayon de courbure voulu R_{c} sans être dégradés structurellement.

En référence à la fig.7H, on retire le substrat poignée 7. Pour cela, avant de procéder au retrait, il est avantageux de procéder à une première réticulation de la couche adhésive intercalaire 6. Celle-ci est effectuée en portant la structure à une première température T₁ de réticulation dite partielle comprise dans la gamme de température de réticulation, ici comprise entre 80°C et 200°C. Cette première température T₁ est inférieure à une deuxième température T₂ de réticulation dite totale appliquée lorsque les composants optiques 10 seront incurvés contre les surfaces courbées 21. Ainsi, la réticulation ici partielle de la couche adhésive intercalaire 6 permet d'améliorer l'assemblage des composants optiques 10 tout en autorisant ensuite leur mise en courbure.

En référence à la fig.7I, on effectue la mise en courbure collective des composants optiques 10. Auparavant, il est avantageux de fragiliser localement la couche adhésive intercalaire 6 au niveau des zones d'appui 10a, de manière à réduire les contraintes mécaniques, notamment de cisaillement, subies par la couche adhésive intercalaire 6 lors de la mise en courbure des composants optiques 10. Pour cela, un tir laser peut être effectué au niveau de la zone d'appui 10a, par exemple au travers du support de mise en forme 20 ou des tranchées 9.

Ensuite, les composants optiques 10 sont incurvés de manière simultanée, jusqu'à ce que leur face inférieure 10i vienne contre la surface courbée 21 correspondante, la couche adhésive intercalaire 6 étant alors située entre et au contact de la face inférieure 10i et de la surface courbée 21. Pour cela, on applique une pression à chacun des composants optiques 10, par exemple par un outil de presse (non représenté), de manière simultanée. Chaque composant optique 10 se déforme et prend la courbure imposée par la surface courbée 21 correspondante. Les composants optiques 10 'glissent' alors le long de la face supérieure du support de mise en forme 20 jusqu'à venir contre les surfaces courbées 21. Ceci est possible dans la mesure où les matériaux des couches adhésives qui réticulent lors d'une montée en température présentent généralement une bonne tenue mécanique à « l'arrachage » (ce qui permet de maintenir les composants optiques 10 lors du retrait du substrat poignée 7) et autorisent toutefois de subir un cisaillement (ce qui permet le glissement des composants optiques 10 lors de leur mise en forme). On obtient ainsi une pluralité de composants optiques 10, tous incurvés suivant la courbure voulue, assemblés au même support de mise en forme 20.

Une montée en température peut également être effectuée pendant ou après la mise en courbure, à une deuxième température T₂ de réticulation de la couche adhésive intercalaire 6, cette température T₂ étant supérieure à la température T₁ précédente, permettant d'obtenir une réticulation plus complète. On améliore ainsi l'assemblage des composants optiques 10 aux surfaces courbées 21.

Le procédé de mise en courbure peut ensuite se poursuivre avec les étapes de structuration du support de mise en forme 20, comme décrit précédemment. Comme dans l'exemple des fig.6A à 6C, dans la mesure où la couche inférieure adhésive 6 présente une épaisseur supérieure à celle des plots conducteurs inférieurs 12, les plots conducteurs 12 ne « percent » pas la couche inférieure adhésive 6 pour venir au contact direct des surfaces courbées 21, les composants optiques 10 peuvent donc présenter effectivement la courbure voulue.

Des modes de réalisation particuliers viennent d'être décrits. Différentes variantes et modifications apparaîtront à l'homme du métier, sans s'écarter de la portée des revendications annexées.

## Revendications

1. Procédé de mise en courbure collective de composants microélectroniques (10), comportant les étapes suivantes :
o réalisation d'une structure microélectronique (1), comportant un substrat microélectronique (2), présentant une face supérieure (2s) et une face inférieure (2i) opposée, comportant une pluralité de composants microélectroniques (10), lesquels comportent chacun des plots conducteurs inférieurs (12) situés sur la face inférieure (2i) et destinés à permettre la connexion électrique du composant microélectronique (10),
o fourniture d'un support de mise en forme (20), présentant une face supérieure (20s) et une face inférieure (20i) opposée, la face supérieure comportant une pluralité de surfaces courbées (21) ;
o dépôt d'une couche inférieure adhésive (6) présentant une épaisseur supérieure à l'épaisseur des plots conducteurs inférieurs (12), de manière à, soit recouvrir entièrement la face inférieure (2i) du substrat microélectronique (2) et les plots conducteurs inférieurs (12) de sorte que la couche inférieure adhésive (6) présente une face inférieure libre (6i) continue et donc non traversée par des plots conducteurs inférieurs (12) qui seraient en saillie hors de cette couche inférieure adhésive (6), soit recouvrir les surfaces courbées (21) ;
o découpe d'au moins le substrat microélectronique (2) pour individualiser les composants microélectroniques (10) ; puis
o report des composants microélectroniques (10) sur le support de mise en forme (20) ; puis
o mise en courbure des composants microélectroniques (10), la couche inférieure adhésive (6) étant alors au contact de la face inférieure (10i) des composants microélectronique (10) et de la surface courbée (21) correspondante, évitant ainsi que les plots conducteurs inférieurs (12) ne soient au contact de la surface courbée (21) ; puis
o réalisation de vias conducteurs (22) s'étendant au travers du support de mise en forme (20) et de la couche inférieure adhésive (6), à partir de la face inférieure (20i) du support de mise en forme (20) pour déboucher sur les plots conducteurs inférieurs (12).

2. Procédé selon la revendication 1, dans lequel les plots conducteurs inférieurs (12) sont disposés sur une ligne de niveau d'une face inférieure (10i) du composant microélectronique (10), la ligne de niveau étant prédéterminée comme étant une ligne d'égale distance à la face inférieure (20i) du support de mise en forme (20), lorsque le composant microélectronique (10) est assemblé au support de mise en forme (20) et est incurvé selon la courbure de la surface courbée (21), les vias conducteurs (22) présentant une dimension verticale uniforme.

3. Procédé selon la revendication 2, comportant, après l'étape de mise en courbure, une étape d'assemblage d'un substrat poignée (8) au support de mise en forme (20) du côté des surfaces courbées (21), de manière à permettre la manipulation de l'empilement ainsi obtenu lors de l'étape de réalisation des vias conducteurs (22).

4. Procédé selon la revendication 3, dans lequel le substrat poignée (8) assemblé au support de mise en forme (20) est assemblé à une extrémité libre de parois latérales (25), lesquelles étant situées entre et entourant les surfaces courbées (21).

5. Procédé selon l'une quelconque des revendications 2 à 4, dans lequel chaque composant microélectronique (10) comporte des plots conducteurs supérieurs (13) situés sur la face supérieure (2s) du substrat microélectronique (2), et des vias conducteurs (14) traversant ce dernier pour déboucher sur la face inférieure (2i) du substrat microélectronique (2), de manière à entourer la ligne de niveau.

6. Procédé selon l'une quelconque des revendications 2 à 5, dans lequel les plots conducteurs inférieurs (12) sont disposés au contact de vias conducteurs (14) des composants microélectronique (10), ou sont décalés vis-à-vis de ces vias conducteurs (14) et en sont reliés par des lignes conductrices (16).

7. Procédé selon l'une quelconque des revendications 1 à 6, comportant, lors de l'étape de réalisation de la structure microélectronique (1), une opération d'assemblage d'un substrat poignée temporaire (7) temporaire au substrat microélectronique (2) du côté de sa face supérieure (2s).

8. Procédé selon la revendication 7, comportant une étape d'amincissement du substrat microélectronique (2), à partir de sa face inférieure (2i) opposée au substrat poignée temporaire (7) assemblé au substrat microélectronique (2).

9. Procédé selon la revendication 7 ou 8, dans lequel, après l'étape de report et avant l'étape de mise en courbure, le substrat poignée temporaire (7) assemblé au substrat microélectronique (2) est retiré de chaque composant microélectronique (10).

10. Procédé selon l'une quelconque des revendications 1 à 9, dans lequel le support de mise en forme (20) est réalisé en un seul bloc et en un même matériau.

11. Procédé selon la revendication 10, dans lequel le support de mise en forme (20) est réalisé en un matériau thermiquement conducteur.

12. Procédé selon l'une quelconque des revendications 1 à 11, dans lequel les composants microélectroniques (10) sont des composants optiques d'émission ou de détection d'un rayonnement lumineux.

13. Procédé selon l'une quelconque des revendications 1 à 12, dans lequel :
o lors de l'étape de report des composants microélectroniques (10) sur le support de mise en forme (20), les composants microélectroniques (10) sont tous assemblés à un même substrat poignée temporaire (7) ;
o l'étape de report des composants microélectroniques (10) sur le support de mise en forme (20) est effectuée de sorte que les composants microélectroniques (10) reposent et adhérent au niveau d'une zone d'appui (10a) de leur face inférieure (10i) sur une surface supérieure de parois latérales (25) du support de mise en forme (20) qui entourent les surfaces courbées (21) ;
o une étape de retrait du substrat poignée (7) est ensuite effectuée ;
o une étape de mise en courbure des composants microélectroniques (10) est ensuite effectuée, de sorte qu'ils soient incurvés, et adhérent sur les surfaces courbées (21) par la couche adhésive intercalaire (6), celle-ci étant alors au contact de la face inférieure (10i) de chaque composant microélectronique (10) et de la surface courbée (21) correspondante.

14. Procédé selon la revendication 13, comportant, avant l'étape de retrait du substrat poignée temporaire (7) assemblé aux composants microélectroniques (10), une montée en température à une première température comprise dans une gamme de température de réticulation de la couche adhésive intercalaire (6), puis, pendant ou après l'étape de mise en courbure, une montée en température à une deuxième température comprise dans la gamme de température de réticulation et supérieure à la première température.

## Patentansprüche

1. Verfahren zum kollektiven Biegen von mikroelektronischen Bauteilen (10), umfassend die folgenden Schritte:
o Ausführen einer mikroelektronischen Struktur (1), umfassend ein mikroelektronisches Substrat (2), aufweisend eine Oberseite (2s) und eine entgegengesetzte Unterseite (2i), umfassend eine Mehrzahl von mikroelektronischen Bauteilen (10), die jeweils untere leitende Kontaktelemente (12) umfassen, die auf der Unterseite (2i) gelegen sind und dazu bestimmt sind, das elektrische Anschließen des mikroelektronischen Bauteils (10) zu ermöglichen,
o Bereitstellen eines Formträgers (20), aufweisend eine Oberseite (20s) und eine entgegengesetzte Unterseite (20i), wobei die Oberseite eine Mehrzahl von gekrümmten Flächen (21) umfasst;
o Aufbringen einer unteren Haftschicht (6), die eine Dicke aufweist, die größer als die Dicke der unteren leitenden Kontaktelemente (12) ist, derart, dass entweder die Unterseite (2i) des mikroelektronischen Substrats (2) und die unteren leitenden Kontaktelemente (12) vollständig bedeckt sind, so dass die untere Haftschicht (6) eine freie Unterseite (6i) aufweist, die durchgehend ist und somit nicht von unteren leitenden Kontaktelementen (12) durchdrungen wird, die aus dieser unteren Haftschicht (6) herausragen würden, oder dass die gekrümmten Flächen (21) bedeckt sind;
o Zerschneiden mindestens des mikroelektronischen Substrats (2), um die mikroelektronischen Bauteile (10) zu vereinzeln; dann
o Übertragen der mikroelektronischen Bauteile (10) auf den Formträger (20); dann
o Biegen der mikroelektronischen Bauteile (10), wobei die untere Haftschicht (6) daraufhin in Kontakt mit der Unterseite (10i) der mikroelektronischen Bauteile (10) und der entsprechenden gekrümmten Fläche (21) ist, wodurch somit verhindert wird, dass die unteren leitenden Kontaktelemente (12) in Kontakt mit der gekrümmten Fläche (21) sind; dann
o Ausführen von leitenden Vias (22), die sich von der Unterseite (20i) des Formträgers (20) aus durch den Formträger (20) und die untere Haftschicht (6) hindurch erstrecken, um auf den unteren leitenden Kontaktelementen (12) zu münden.

2. Verfahren nach Anspruch 1, bei dem die unteren leitenden Kontaktelemente (12) auf einer Niveaulinie einer Unterseite (10i) des mikroelektronischen Bauteil (10) angeordnet sind, wobei die Niveaulinie vorbestimmt ist als eine Linie, die in gleichem Abstand zur Unterseite (20i) des Formträgers (20) ist, wenn das mikroelektronische Bauteil (10) an dem Formträger (20) montiert ist und gemäß der Krümmung der gekrümmten Oberfläche (21) gebogen ist, wobei die leitenden Vias (22) ein einheitliches vertikales Maß aufweisen.

3. Verfahren nach Anspruch 2, umfassend, nach dem Schritt des Biegens, einen Schritt des Montierens eines Griffsubstrats (8) an dem Formträger (20) auf der Seite der gekrümmten Flächen (21), so dass die Handhabung des so erhaltenen Stapels beim Schritt des Ausführens der leitenden Vias (22) ermöglicht wird.

4. Verfahren nach Anspruch 3, bei dem das an dem Formträger (20) montierte Griffsubstrat (8) an einem freien Ende von seitlichen Wänden (25) montiert wird, die zwischen den gekrümmten Flächen (21) gelegen sind und diese umgeben.

5. Verfahren nach einem der Ansprüche 2 bis 4, bei dem jedes mikroelektronische Bauteil (10) obere leitende Kontaktelemente (13) umfasst, die auf der Oberseite (2s) des mikroelektronischen Substrats (2) gelegen sind, und leitende Vias (14), die Letzteres durchdringen, um auf der Unterseite (2i) des mikroelektronischen Substrats (2) derart zu münden, dass sie die Niveaulinie umgeben.

6. Verfahren nach einem der Ansprüche 2 bis 5, bei dem die unteren leitenden Kontaktelemente (12) in Kontakt mit leitenden Vias (14) der mikroelektronischen Bauteile (10) angeordnet sind oder gegenüber diesen leitenden Vias (14) versetzt sind und mit ihnen durch leitende Bahnen (16) verbunden sind.

7. Verfahren nach einem der Ansprüche 1 bis 6, umfassend, beim Schritt des Ausführens der mikroelektronischen Struktur, (1) einen Vorgang des Montierens eines temporären Griffsubstrats (7) an dem mikroelektronischen Substrat (2) auf der Seite seiner Oberseite (2s).

8. Verfahren nach Anspruch 7, umfassend einen Schritt des Verdünnens des mikroelektronischen Substrats (2) ausgehend von seiner Unterseite (2i), die entgegengesetzt zu dem temporären Griffsubstrat (7) ist, das an dem mikroelektronischen Substrat (2) montiert ist.

9. Verfahren nach Anspruch 7 oder 8, bei dem, nach dem Schritt des Übertragens und vor dem Schritt des Biegens, das an dem mikroelektronischen Substrat (2) montierte temporäre Griffsubstrat (7) von jedem mikroelektronischen Bauteil (10) entfernt wird.

10. Verfahren nach einem der Ansprüche 1 bis 9, bei dem der Formträger (20) aus einem einzigen Block und aus gleichem Material ausgeführt ist.

11. Verfahren nach Anspruch 10, bei dem der Formträger (20) aus einem thermisch leitenden Material ausgeführt ist.

12. Verfahren nach einem der Ansprüche 1 bis 11, bei dem die mikroelektronischen Bauteile (10) optische Bauteile zum Aussenden oder Detektieren einer Lichtstrahlung sind.

13. Verfahren nach einem der Ansprüche 1 bis 12, bei dem:
o beim Schritt des Übertragens der mikroelektronischen Bauteile (10) auf den Formträger (20) die mikroelektronischen Bauteile (10) alle an einem selben temporären Griffsubstrat (7) montiert werden;
o der Schritt des Übertragens der mikroelektronischen Bauteile (10) auf den Formträger (20) so durchgeführt wird, dass die mikroelektronischen Bauteile (10) an einem Auflagebereich (10a) ihrer Unterseite (10i) auf einer oberen Fläche von Seitenwänden (25) des Formträgers (20), die die gekrümmten Flächen (21) umgeben, aufliegen und haften;
o ein Schritt des Entfernens des Griffsubstrats (7) anschließend durchgeführt wird;
o ein Schritt des Biegens der mikroelektronischen Bauteile (10) anschließend durchgeführt wird, so dass sie gebogen werden und auf den gekrümmten Flächen (21) über die Haftzwischenschicht (6) haften, wobei diese daraufhin in Kontakt mit der Unterseite (10i) jedes mikroelektronischen Bauteils (10) und mit der entsprechenden gekrümmten Fläche (21) ist.

14. Verfahren nach Anspruch 13, umfassend, vor dem Schritt des Entfernens des an den mikroelektronischen Bauteilen (10) montierten temporären Griffsubstrats (7), einen Temperaturanstieg auf eine erste Temperatur, die in einem Vernetzungstemperaturbereich der Haftzwischenschicht (6) enthalten ist, dann, während oder nach dem Schritt des Biegens, einen Temperaturanstieg auf eine zweite Temperatur, die in dem Vernetzungstemperaturbereich enthalten ist und höher als die erste Temperatur ist.

## Claims

1. Wafer-level process for bending microelectronic components (10), comprising the following steps:
o producing a microelectronic structure (1), comprising a microelectronic substrate (2), having an upper face (2s) and an opposite lower face (2i), comprising a plurality of microelectronic components (10), which each comprise lower conductive pads (12) located on the lower face (2i) and intended to allow the microelectronic component (10) to be connected electrically;
o providing a shaping carrier (20), having an upper face (20s) and an opposite lower face (20i), the upper face comprising a plurality of curved surfaces (21);
o depositing an adhesive lower layer (6) having a thickness larger than the thickness of the lower conductive pads (12), so as either to entirely cover the lower face (2i) of the microelectronic substrate (2) and the lower conductive pads (12) such that the adhesive lower layer (6) has a free lower face (6i) that is continuous and therefore not passed right through by the lower conductive pads (12) which would otherwise protrude from this adhesive lower layer (6), or to cover the curved surfaces (21);
o dicing at least the microelectronic substrate (2) to singulate the microelectronic components (10); then
o transferring the microelectronic components (10) to the shaping carrier (20); then
o bending the microelectronic components (10), the adhesive lower layer (6) then making contact with the lower face (10i) of the microelectronic components (10) and with the corresponding curved surface (21), thus preventing the lower conductive pads (12) from making contact with the curved surface (21); then
o producing conductive vias (22) that extend through the shaping carrier (20) and the adhesive lower layer (6), from the lower face (20i) of the shaping carrier (20), in order to emerge onto the lower conductive pads (12).

2. Process according to Claim 1, wherein the lower conductive pads (12) are placed on an isoline of a lower face (10i) of the microelectronic component (10), the isoline being predetermined as being a line of equidistance to the lower face (20i) of the shaping carrier (20), when the microelectronic component (10) has been joined to the shaping carrier (20) and is bent with the curvature of the curved surface (21), the conductive vias (22) having a uniform vertical dimension.

3. Process according to Claim 2, comprising, after the bending step, a step of joining a handle substrate (8) to the shaping carrier (20) on the side of the curved surfaces (21), so as to allow the stack thus obtained to be handled in the step of producing the conductive vias (22).

4. Process according to Claim 3, wherein the handle substrate (8) joined to the shaping carrier (20) is joined to a free end of sidewalls (25), which are located between and encircle the curved surfaces (21).

5. Process according to any one of Claims 2 to 4, wherein each microelectronic component (10) comprises upper conductive pads (13) located on the upper face (2s) of the microelectronic substrate (2), and conductive vias (14) passing through the latter in order to emerge onto the lower face (2i) of the microelectronic substrate (2), so as to encircle the isoline.

6. Process according to any one of Claims 2 to 5, wherein the lower conductive pads (12) are placed in contact with conductive vias (14) of the microelectronic components (10), or are offset with respect to these conductive vias (14) and are connected thereto by conductive lines (16).

7. Process according to any one of Claims 1 to 6, comprising, in the step of producing the microelectronic structure (1), an operation of joining a temporary handle substrate (7) to the microelectronic substrate (2) on the side of its upper face (2s).

8. Process according to Claim 7, comprising a step of thinning the microelectronic substrate (2), from its lower face (2i) opposite the temporary handle substrate (7) joined to the microelectronic substrate (2).

9. Process according to Claim 7 or 8, wherein, after the transferring step and before the bending step, the temporary handle substrate (7) joined to the microelectronic substrate (2) is removed from each microelectronic component (10).

10. Process according to any one of Claims 1 to 9, wherein the shaping carrier (20) is a single piece of a given material.

11. Process according to Claim 10, wherein the shaping carrier (20) is made of a thermally conductive material.

12. Process according to any one of Claims 1 to 11, wherein the microelectronic components (10) are optical components for emitting or detecting light radiation.

13. Process according to any one of Claims 1 to 12, wherein:
o in the step of transferring the microelectronic components (10) to the shaping carrier (20), the microelectronic components (10) are all joined to the same temporary handle substrate (7);
o the step of transferring the microelectronic components (10) to the shaping carrier (20) is carried out so that the microelectronic components (10) rest on and adhere to, via a bearing region (10a) of their lower face (10i), an upper surface of sidewalls (25) of the shaping carrier (20) that encircle the curved surfaces (21);
o a step of removing the handle substrate (7) is then carried out;
o a step of bending the microelectronic components (10) is then carried out, so that they are bent, and adhere to the curved surfaces (21) via the intermediate adhesive layer (6), the latter then making contact with the lower face (10i) of each microelectronic component (10) and with the corresponding curved surface (21).

14. Process according to Claim 13, comprising, before the step of removing the temporary handle substrate (7) joined to the microelectronic components (10), increasing temperature to a first temperature comprised in a temperature range of cross-linkage of the intermediate adhesive layer (6), then, during or after the bending step, increasing temperature to a second temperature comprised in the cross-linkage temperature range and above the first temperature.
